(19) Europäisches Patentamt
European Patent Office
Office européen des brevets

(11) **EP 1 265 105 B1**

(12) **EUROPEAN PATENT SPECIFICATION**

(45) Date of publication and mention
of the grant of the patent:
**22.04.2009 Bulletin 2009/17**

(51) Int Cl.:
***G03F 7/20*** (2006.01)

(21) Application number: **02253824.3**

(22) Date of filing: **30.05.2002**

(54) **Lithographic apparatus and device manufacturing method**

Lithographischer Apparat und Verfahren zur Herstellung eines Artikels

Appareil lithographique et méthode pour la fabrication d'un dispositif

(84) Designated Contracting States:
**DE FR GB IT NL**

(30) Priority: **31.05.2001 EP 01304816**

(43) Date of publication of application:
**11.12.2002 Bulletin 2002/50**

(73) Proprietor: **ASML Netherlands B.V.**
**5504 DR Veldhoven (NL)**

(72) Inventors:
• **Hol, Sven Antoin Johan**
**5623 AW Eindhoven (NL)**
• **Buis, Edwin Johan**
**5951 GZ Belfeld (NL)**
• **De Weerdt, Robrecht Emiel Maria Leonia**
**2322 Hoogstraten (BE)**

(74) Representative: **Van den Hooven, Jan et al**
**ASML Netherlands B.V.**
**Corporate Intellectual Property**
**P.O. Box 324**
**5500 AH Veldhoven (NL)**

(56) References cited:
**EP-A- 1 001 512**          **EP-A- 1 243 969**
**US-A- 4 506 205**          **US-A- 5 608 773**
**US-A- 5 780 943**          **US-A- 5 844 666**

## Description

The present invention relates to a lithographic projection apparatus comprising:

- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. An example of such a device is a matrix-addressable surface having a viscoelastic control layer and a reflective surface. The basic principle behind such an apparatus is that (for example) addressed areas of the principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. The required matrix addressing can be performed using suitable electronic means. More information on such mirror arrays can be gleaned, for example, from United States Patents US 5,296,891 and US 5,523,193, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus — commonly referred to as a step-and-scan apparatus — each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Twin stage lithographic apparatus are described, for example, in US 5,969,441 and WO 98/40791, incorporated herein by reference.

Within lithographic apparatus supports are required that provide a permanent force to oppose gravity. For instance quasi-static supports are required to support an isolated reference frame (which supports the projection system and various sensor devices) and isolate it from external vibrations. Dynamic supports are, for instance, required to support a short-stroke module for a substrate or patterning means on a long-stroke module. In such dynamic supports a static force component is provided to support the weight of the short-stroke module and a dynamic force component is provided to drive the short-stroke module. In both static and dynamic supports it is important that the support has very low stiffness to prevent the transmission of vibrations.

Previously air-mounted bearings have been used to provide the static supports to support and isolate the metrology frame. Whilst these systems do provide supports with very low stiffness, they have the disadvantage that they are relatively complicated, require a supply of compressed air (which in turn requires a compressor which produces vibrations that must be isolated from the lithographic apparatus) and are not suitable for use in a vacuum.

Previous solutions for both dynamic and static supports included the use of a pneumatic support to compensate for gravity. A pneumatic support is, for instance, disclosed in WO 99/05573 and EP 0,973,067 and may include a piston supported by a pressurized gas in a pressure chamber of a cylinder in which the piston is being journalled by a gas-bearing. The pneumatic support may require a rather large volume of pressurized gas to provide a good isolation from vibrations, and any turbulence and pressure variations in the pressurized gas will be transmitted to the piston and the supported object, which may make their application less effective and inconvenient. Prevention of transmission of vibrations in the support direction is quite successful but prevention of vibrations in a plane perpendicular to the support direction requires further measures such as a further gas-bearing allowing for frictionless movement in the perpendicular direction. Both a gas-bearing and a pneumatic support are not very well compatible with a vacuum environment.

Further, it has been proposed to provide a supporting force by means of magnetic attraction and/or repulsion such as, for instance, disclosed in EP 1,001,512 or US 5,780943. US 5,780,943 discloses a lithographic apparatus having a wafer table support comprising first, second and third magnets, the first and third magnets are attached to a leveling stage and the second magnet is arranged between them and attached to the wafer table. However, the proposed solutions provide a supporting force that may be positional dependent both along and perpendicular to the support direction. The proposed solutions may also be subject to demagnetization effects.

It is an object of the present invention to provide supports which are relatively simple, suitable for use in a vacuum, require minimal services (such as compressed air and cooling) and provide substantially constant support within a defined operating volume, both along and perpendicular to the support direction.

It is yet another object of the invention to provide magnetic supports which take a small overall volume since space is generally very limited in lithographic apparatus where such magnetic supports may find their application.

Yet another object of the invention is to provide magnetic supports of which a nominal supporting force is easily adjustable.

Yet another object of the invention is to provide magnetic supports that may efficiently be combined with a current carrying element for providing an additional force along the support direction.

This and other objects are achieved according to the invention in a lithographic apparatus as specified in the opening paragraph, further comprising a support that provides a magnetic force in a first, support, direction between a first part and a second part of the apparatus, wherein the support comprises first, second and third magnet assemblies and:

- said first and third magnet assemblies are attached to said first part and each comprises at least one magnet orientated such that its magnetic polarization is substantially parallel or anti-parallel to said first direction;

- said second magnet assembly is attached to the second part and comprises at least one magnet; and
- said at least one magnet of said second magnet assembly has its magnetic polarization oriented so as to produce a bias force substantially along said first direction by magnetic interaction between said first, second and third magnet assemblies;

characterised in that said first and third magnet assemblies are set apart in a direction that is substantially perpendicular to the first direction and define a space between them; and said second magnet assembly is at least partly located in said space.

Such a configuration of magnets provides a considerable volume in which the second magnet assembly can move without any substantial variation in the supporting force. This provides for a very low stiffness support both along and perpendicular to the support direction.

In an advantageous embodiment of the present invention at least one of the first, second and third magnet assemblies is comprised of at least one permanent magnet. This is advantageous since electromagnets, in comparison, constantly require an electric current to provide the bias force. This in turn produces heat which must be dissipated and may necessitate additional cooling apparatus.

In an advantageous arrangement of the invention, the second magnet assembly circumscribes or encloses the first magnet assembly and the third magnet assembly circumscribes or encloses the second magnet assembly in a plane perpendicular to the first direction. Preferably at least one of the first, second and third magnet assemblies is annular in a cross-section perpendicular to the first direction. This is advantageous because variations in the magnet strength will have less effect on the characteristics of the magnetic support.

In a further advantageous arrangement of the present invention at least one of the first and third magnet assemblies comprises two magnets which can be adjusted so as to vary their relative positions. This is advantageous as it allows the bias force to be altered depending on the load that the support is required to carry.

In an advantageous embodiment of the present invention a magnet of the third magnet assembly is orientated such that its magnetic polarization is substantially parallel to the magnetic polarization of a magnet of the first magnet assembly and a magnet of the second magnet assembly is orientated such that its magnetic polarization is substantially parallel or anti-parallel to that of a magnet of the first magnet assembly. This embodiment is advantageous as the resulting support may be relatively slender for a given size of bias force provided.

In an alternative advantageous embodiment a magnet of the third magnet assembly is orientated such that its magnetic polarization is substantially anti-parallel to that of a magnet of the first magnet assembly and a magnet of the second magnet assembly is orientated such that its magnetic polarization is substantially perpendicular to that of a magnet of the first magnet assembly. This embodiment is advantageous as it provides a support that has a relatively large travel within a given range of the maximum static force for a given size of the magnetic support.

In a further advantageous arrangement of the invention, the support may further comprise an electrically conductive element, connectable to a power supply arranged so as to produce a force between the first and second parts of the apparatus by interaction between an electrical current carried by said electrically conductive element and a magnetic field of at least one of said first, second and third magnet assemblies. This is advantageous as the resulting force may be used to control the separation of the first and second parts of the lithographic apparatus.

According to yet a further aspect of the invention there is provided a device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material;
- providing a support that provides a magnetic force in a first, support, direction between a first part and a second part of the apparatus, comprising first, second and third magnet assemblies, and in that:

- said first and third magnet assemblies are attached to said first part and each comprises at least one magnet orientated such that its magnetic polarization is substantially parallel or anti-parallel to said first direction;
- said second magnet assembly is attached to the second part and comprises at least one magnet; and
- said at least one magnet of said second magnet assembly has its magnetic polarization orientated so as to produce a bias force substantially along said support direction by magnetic interaction between said first, second and third magnet assemblies;

characterised in that said first and third magnet assemblies are set apart in a direction that is substantially perpendicular to the first direction and define a space between them; and said second magnet assembly is at least partly located in said space.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and extreme ultra-violet (EUV) radiation, (*e.g.* having a wavelength in the range 5-20 nm), as well as particle beams, such as ion beams or electron beams.

Embodiments of the invention will now be described, by way of example only, with reference to the accompanying schematic drawings in which:

Figure 1 depicts a lithographic projection apparatus according to an embodiment of the invention;
Figure 2a shows the schematic layout of the magnets for one configuration according to the present invention;
Figure 2b shows magnetic field lines calculated for the configuration of Figure 2a;
Figure 3a shows the schematic layout of the magnets for a further configuration according to the present invention;
Figure 3b shows magnetic field lines calculated for the configuration of Figure 3a;
Figure 4a shows the schematic layout of the magnets for a further configuration according to the present invention;
Figure 4b shows magnetic field lines calculated for the configuration of Figure 4a;
Figure 5a shows the schematic layout of one half of an axially symmetric support according to the present invention;
Figure 5b shows magnetic filed lines calculated for the support shown in Figure 6a;
Figures 6a and 6b show the results of a first simulation of a support according to the arrangement of Figure 5a; and, in particular,

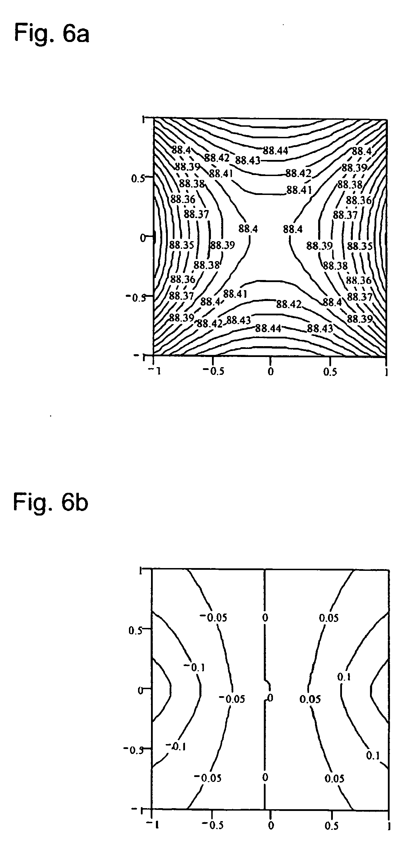

Figure 6a shows a contour plot of the supporting force in Newton (N) for vertical (y-axis, $\pm 1$ mm) and horizontal (x-axis, $\pm 1.5$ mm) movements;
Figure 6b shows a contour plot of the radial force in Newton (N) for vertical (y-axis, $\pm 1$ mm) and horizontal (x-axis, $\pm 1.5$ mm) movements;

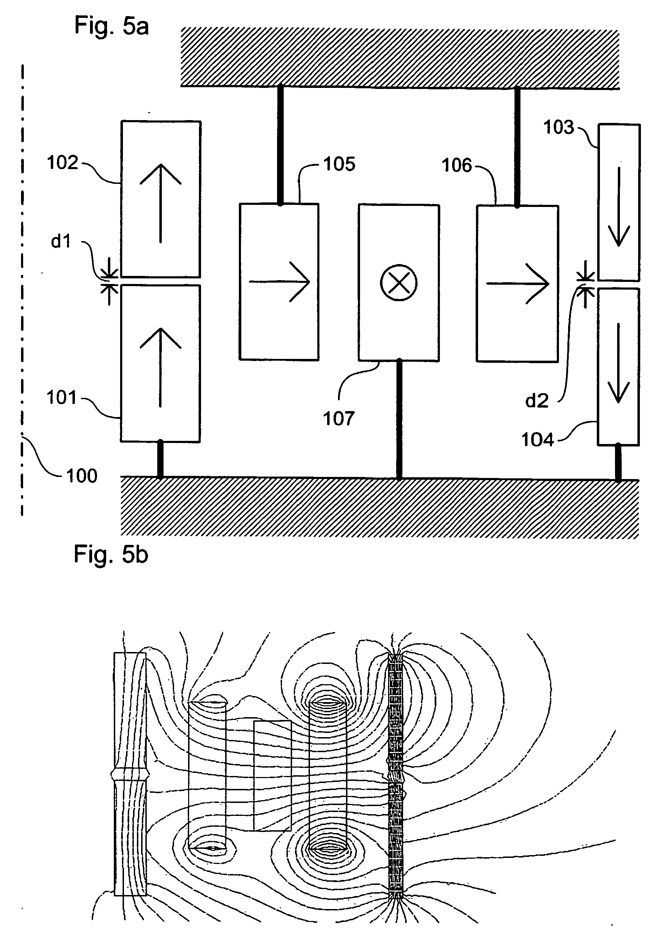

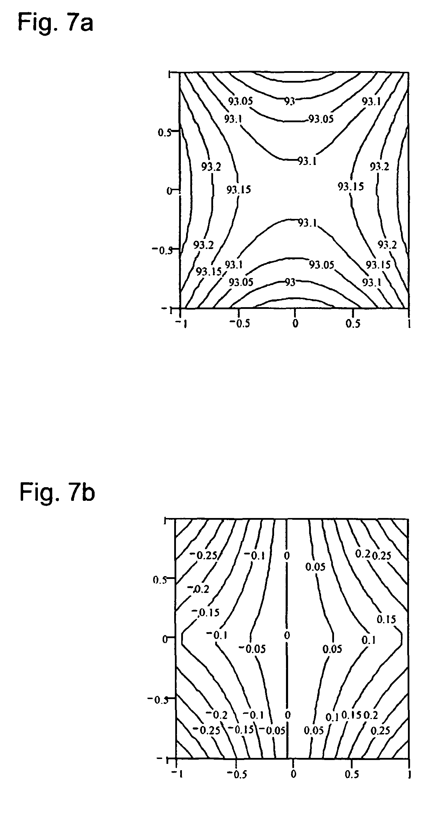

Figures 7a and 7b show the results of a second simulation of a support according to the arrangement of Figure 5a; and, in particular,
Figure 7a shows a contour plot of the supporting force in Newton (N) for vertical (y-axis, $\pm 1$ mm) and horizontal (x-axis, $\pm 1.5$ mm) movements;
Figure 7b shows a contour plot of the radial force in Newton (N) for vertical (y-axis, $\pm 1$ mm) and horizontal (x-axis, $\pm 1.5$ mm) movements;

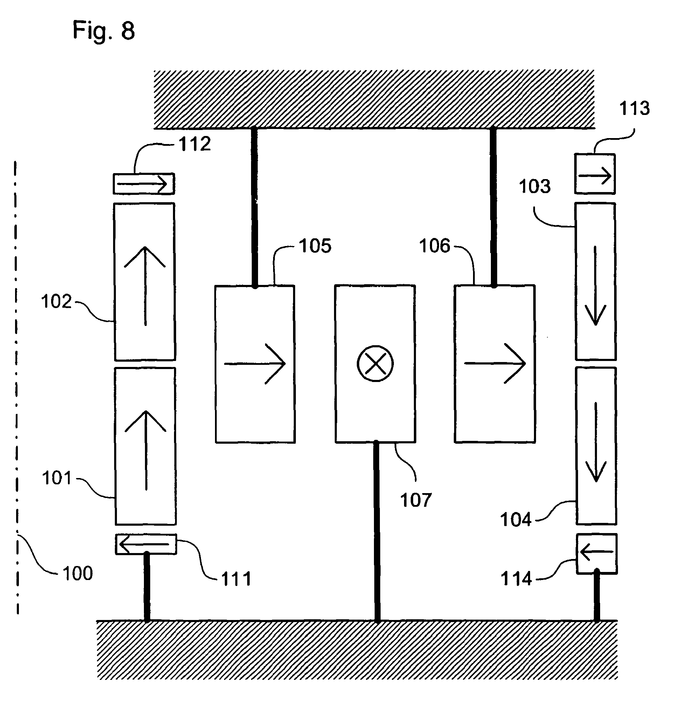

Figure 8 shows the schematic layout of a variant of the support of Figure 5a;

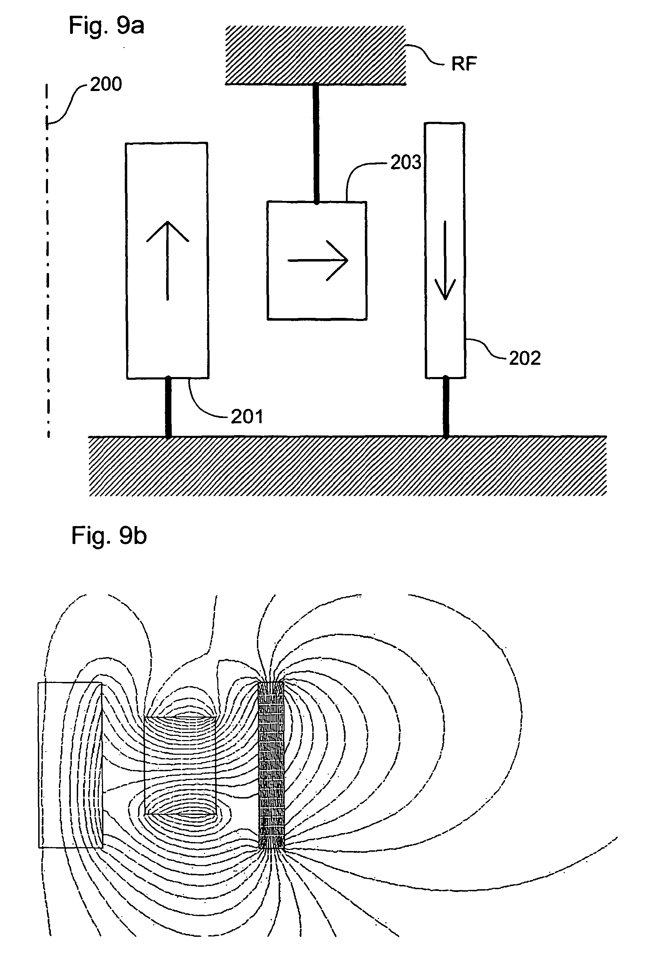

Figure 9a shows the schematic layout of one half of a further axially symmetric support according to the present invention;
Figure 9b shows the magnetic filed lines calculated for the support shown in Figure 7a;

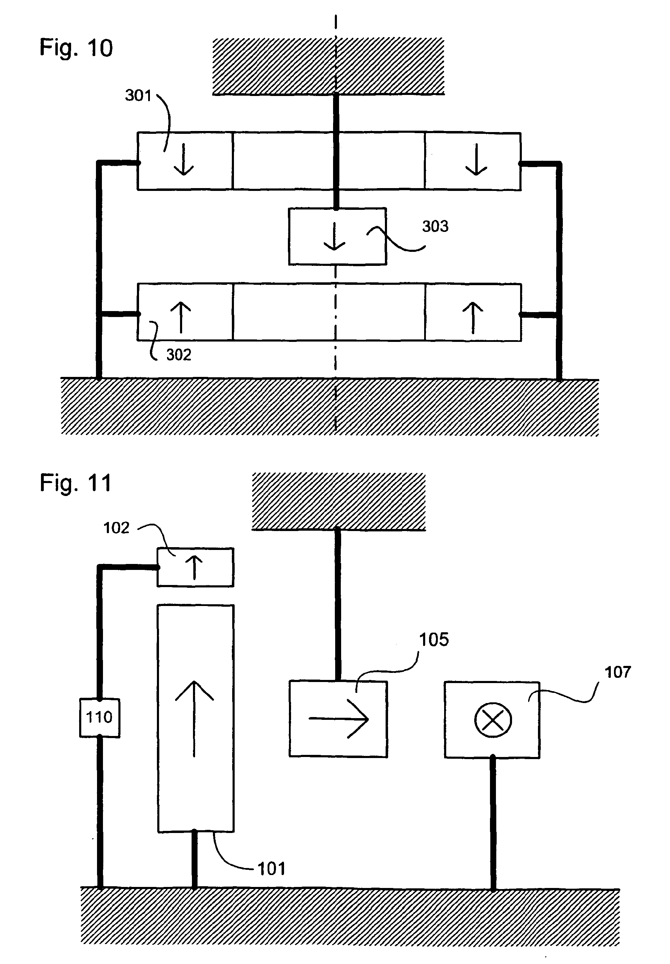

Figure 10, 11 and 12 show further schematic lay-outs of embodiments of a magnetic support according to the invention.

In the Figures, corresponding reference symbols indicate corresponding parts.

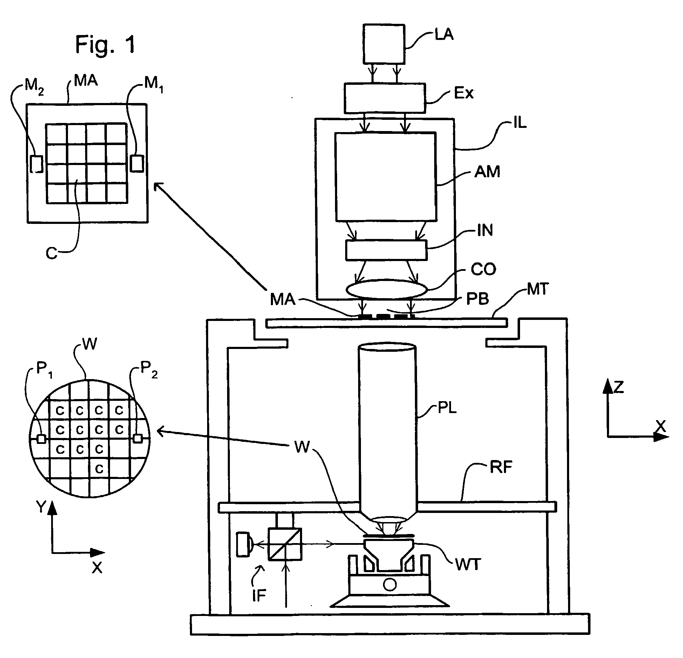

Figure 1 schematically depicts a lithographic projection apparatus according to a particular embodiment of the invention. The apparatus comprises:

· a radiation system Ex, IL, for supplying a projection beam PB of radiation (*e.g.* UV or EUV radiation). In this particular case, the radiation system also comprises a radiation source LA;
· a first object table (mask table) MT provided with a mask holder for holding a mask MA (*e.g.* a reticle), and connected to first positioning means for accurately positioning the mask with respect to item PL;
· a second object table (substrate table) WT provided with a substrate holder for holding a substrate W (*e.g.* a resist-coated silicon wafer), and connected to second positioning means for accurately positioning the substrate with respect to item PL;
· a projection system ("lens") PL (*e.g.* a refractive or catadioptric system, a mirror group or an array of field deflectors) for imaging an irradiated portion of the mask MA onto a target portion C (*e.g.* comprising one or more dies) of the substrate W.

As here depicted, the apparatus is of a transmissive type (*i.e.* has a transmissive mask). However, in general, it may also be of a reflective type, for example (with a reflective mask). Alternatively, the apparatus may employ another kind of patterning means, such as a programmable mirror array of a type as referred to above.

The source LA (*e.g.* an excimer laser, an undulator or wiggler provided around the path of an electron beam in a storage ring or synchrotron, a laser-produced plasma source, a discharge source or an electron or ion beam source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;

2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed $V = Mv$, in which $M$ is the magnification of the lens PL (typically, $M = 1/4$ or $1/5$). In this manner, a relatively large target portion C can be exposed, without having to compromise on resolution.

Some conceptual arrangements of the invention will now be described with reference to the drawings.

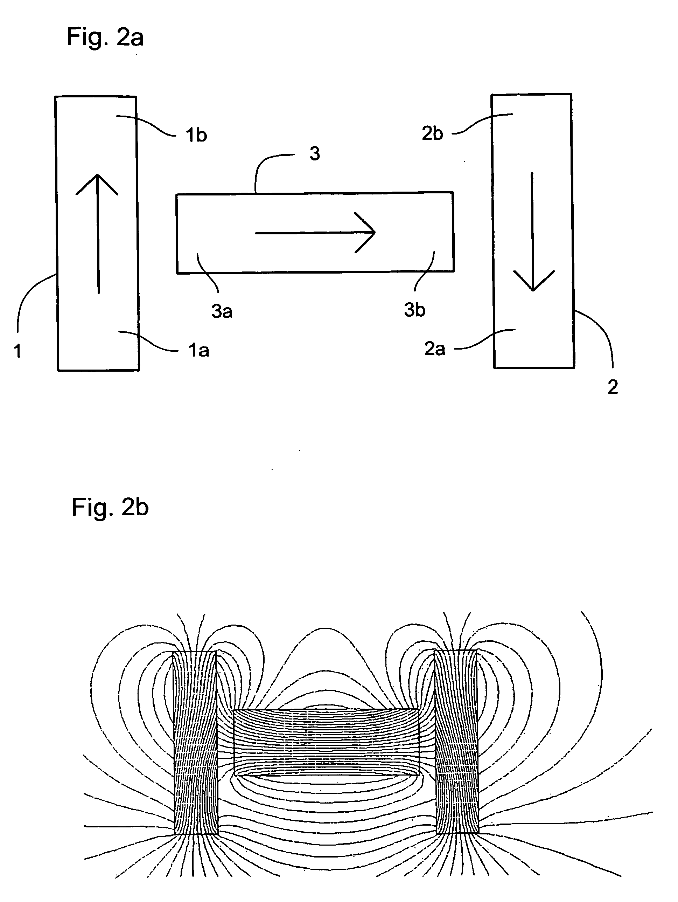

Figures 2a and 2b show a configuration of magnets according to the present invention and the corresponding magnetic field lines that this configuration produces. In this configuration a first and a third permanent magnet 1, 2 are arranged on a base part (not shown) of the apparatus from which an element is to be supported. The base may be attached to the floor on which the apparatus is installed, in which case the element to be supported could be an isolated reference frame RF, or the base may be a dynamic component such as a long-stroke module supporting a short-stroke module of one of the object tables. The magnets are arranged such that their magnetic polarization is vertical and opposite to one another. A second magnet 3 is attached to the element to be supported (also not shown). It is arranged such that its magnetic polarization is horizontal and it is located between the first and third magnets 1, 2 attached to the base. However, the configuration might also comprise electromagnets in place of the permanent magnets. In a variation, magnet 3 is attached to the base and magnets 1, 2 to the element to be supported.

The magnetic interaction produces a vertical force on the second magnet 3 relative to the first and third magnets 1, 2 and therefore provides a vertical force to support the element being supported from the base. This force is produced because the left hand pole 3a (as shown) of the second magnet 3 is repelled from the bottom pole la of the first magnet 1 and attracted to the top pole 1b while the right hand pole 3b of the second magnet 3 is repelled by the bottom pole 2a of the third magnet 2 and attracted to the top pole 2b.

Within a vertical range, the vertical force on the second magnet 3 only varies slightly, which results in low stiffness, since the magnetic field density variations are small. The second magnet experiences negative stiffness at the upper poles 1b 2b of the first and third magnets 1, 2 and positive stiffness at the bottom two poles la, 2a which substantially cancel to result in very low overall stiffness. Furthermore the variation of the vertical force upon a horizontal movement (within the plane of the drawing) of the second magnet is also found to be very small.

This configuration is advantageous because it produces a high vertical force and has low stiffness in the vertical and horizontal directions. Furthermore, there is minimal risk of the magnets becoming demagnetized and, as a result of the symmetry of the configuration, the moment around an axis perpendicular to the figure is minimal. Compensation for any unbalance in the vertical force between the first and third magnets 1,2 may be compensated for by applying a horizontal offset to one or other of the first and third magnets.

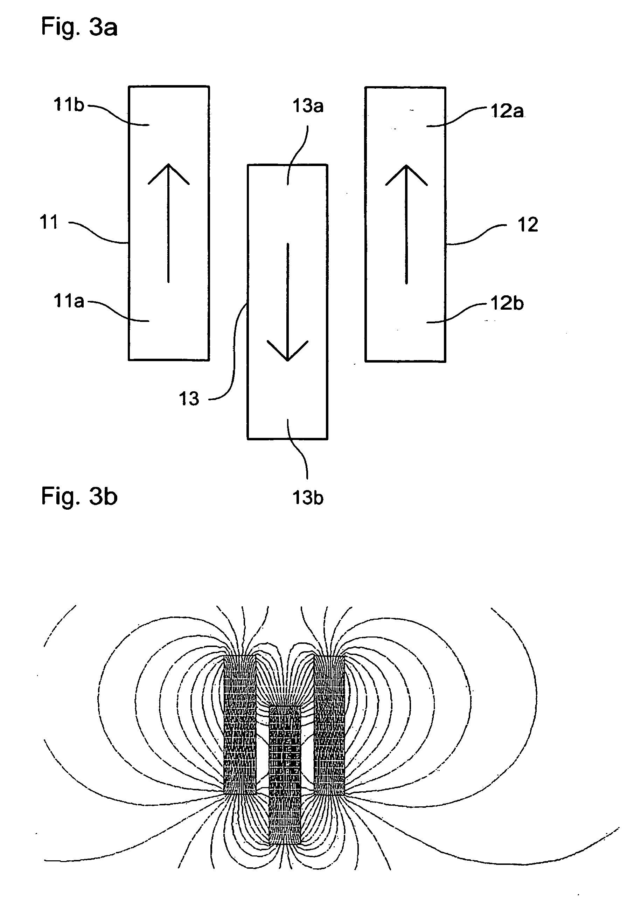

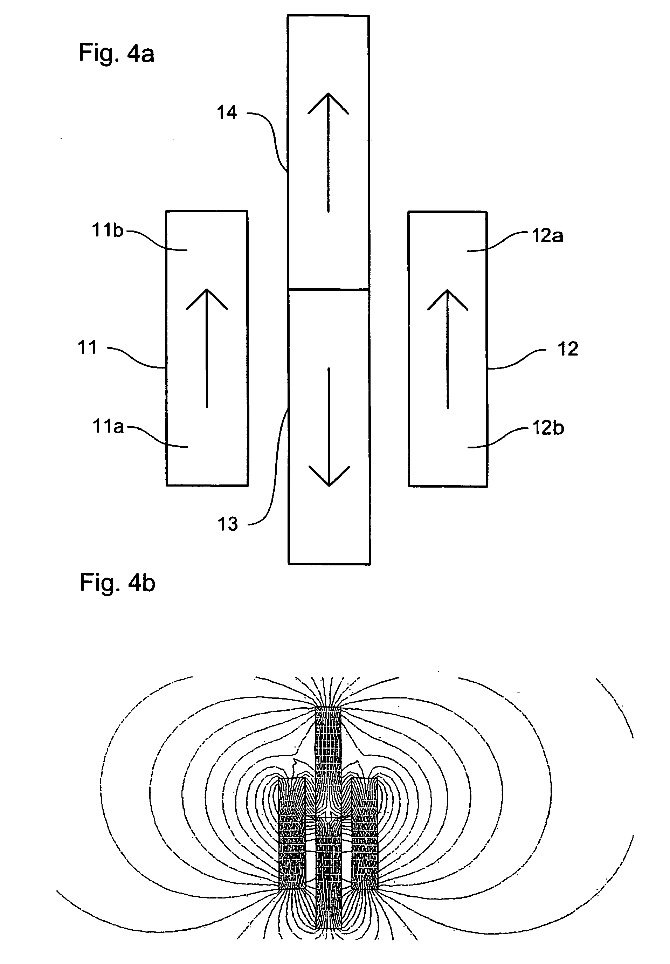

Figures 3a and 3b show a different configuration of magnets according to the present invention and the corresponding magnetic field lines that the configuration produces. The configuration is similar to that shown in Figures 2a and 2b but in this configuration the first and third magnets 11, 12 are arranged such that their magnetic polarization is in the same direction (orientated upwards or downwards) and the second magnet 13 is arranged such that its magnetic polarization is vertical and opposite (anti-parallel) or parallel to that of the first and third magnets. In the case the magnetic polarization is oriented anti-parallel, it will partly project downward from the space between magnets 11, 12 having an upward oriented magnetic polarization as shown in Figures 3a and 4a. In case the second magnet has a parallel magnetic orientation, it will project upwards as is shown for magnet 14 in Figure 4a. As before, the first and third magnets are attached to the base and the second magnet is attached to the element being supported (or vice versa).

This configuration produces similar stiffnesses and forces to the first configuration, described above, but advantageously the width is smaller.

As before, the magnets may be electromagnets, but are advantageously permanent magnets. The latter require no electrical currents and therefore do not result in power dissipation, corresponding heat loads and temperature variations of the various elements, for which cooling may be inconvenient, especially in a vacuum environment.

Figures 4a and 4b show a further configuration of magnets according to the present invention (which is a variation of that shown in Figures 3a and 3b) and the corresponding magnetic field lines that the configuration produces. The difference between the configuration shown in Figures 3a and 3b and the configuration shown in Figures 4a and 4b is the presence of a fourth magnet 14 connected to the second magnet 13. The fourth magnet is arranged such that its magnetic polarization is opposite to that of the second magnet. This configuration provides a larger vertical supporting force than the configuration shown in Figures 3a and 3b.

All of the above described conceptual arrangements can also be used in corresponding arrangements with rotational symmetry (i.e. annular and/or cylindrical arrangements in which once half of the cross section would be essentially the same as that described above). Rotational symmetric arrangements are advantageous because variations in the magnet strength have less effect on the characteristics of the support.

The conceptual embodiments shown in figures 2a, 3a and 4a (and also in figure 9a) may prove to be advantageous with respect to a low overall stiffness in a large working volume provided by those configurations having one or more magnets of one magnet assembly at least partly located in a space defined between magnets of another magnet assembly. However, the magnetic may also function satisfactory when having one of the magnets 1, 2; 11, 12; 201, 202 of the latter assembly left away. It may result in some larger stiffness in the same working volume, but having the advantage of a less complex and smaller magnetic support unit. Especially the configurations of figures 3a and 4a having one of the magnets 11 or 12 left out would result in a magnetic support having a very small width. For configurations having rotational symmetry this would mean leaving out one of the inner our outer magnets.

In order to produce efficient support devices it is currently intended to use magnetic materials with high energy densities, such as Neodymium Iron Boron (NdFeB) or Samarium Cobalt. However, other permanent magnets may also be used.

Figure 5a schematically shows an arrangement that may be used to as a dynamic support for the short-stroke module of a substrate table or the support for a patterning means. Figure 5b shows the resultant field lines for the arrangement of Figure 6a.

The arrangement schematically shown in Figure 5a is a variant of that shown in Figure 2a. The first and third magnets are split into two parts 101,102 and 103, 104, respectively. The second magnet is also split into two parts 105, 106 and a coil is added between the two parts of the second magnet. Furthermore this arrangement has rotational (axial) symmetry around an axis 100, such that each of the magnets and the coil has an annular shape in a cross-section perpendicular to axis 100. The first and third magnets 101, 102, 103, 104 and the coil 107 are mounted on the base (schematically shown), which in this arrangement is the long-stroke module, and the second magnets 105, 106 are mounted on the short-stroke module being supported.

Adjustment of the distance dl between the two parts of the first magnet 101, 102 and the distance d2 between the two parts of the third magnet 103, 104 adjusts the static force component between the short-stroke and long-stroke modules. This allows the static force component to be tuned to the weight of the short-stroke module. The coil 107 provides a dynamic force component. A controlled current (perpendicular to the plane of the drawing) through the coil interacts with the magnetic field of the second magnets to produce a Lorentz force that adds to, or subtracts from, the static force component between the short-stroke and long-stroke modules thereby producing a net force on the short-stroke module relative to the long-stroke module.

Figures 6a, 6b show the vertical and horizontal static forces, respectively, in Newton (N) for horizontal (radial) and vertical (axial) movements of the second magnets 105, 106 to the first and third magnets 101, 102, 103, 104 and coil 107 as derived by simulations of an arrangement as shown in Figure 5a. Forces and torques are derived by integration of the Maxwell stress tensor along the magnetic field lines. Table 1, below, shows the dimensions of the elements in the simulation, $\varnothing_{inner}$ and $\varnothing_{outer}$ referring to the inner and outer diameter, respectively, of an element in millimeter (mm). The material of the permanent magnets is NdFeB having a magnetic remanence $B_r$=1.38 Tesla (T) and a magnetic permeability $\mu_r$=1.05. The coil is copper wire (fill factor 0.8). As shown, the vertical force remains largely constant and the horizontal force is much smaller than the vertical force. The distances dl, d2 between the two parts of the first and third magnets 101, 102, 103, 104 were 0.2 mm. Distances d1, d2 may also be varied independently. Tables 2, 3, and 4, below, summarize the results of the simulation for three different distances dl, d2 between the two parts of the first and third magnets 101, 102, 103, 104. Stiffness is shown in Newton per meter (N/m) and torque in milliNewton meter (mNm). The k-factor refers to a value of the Lorentz force per unit of electrical current through coil 107. Values presented are for a cubic working volume of x = ±1.5 mm, y = ±1.5 mm and z = ±1 mm.

Figures 7a and 7b show results which correspond to those shown in Figures 6a and 6b, respectively, for a second simulation in which the dimensions of the elements are those shown in Table 5, below. (It is noted that the values on the horizontal axis of Figures 6a, 6b, 7a and 7b should be multiplied by 1.5). Other aspects of the simulation were the same. Tables 6, 7, and 8, below, summarize the results of the second simulation for three different distances d1, d2 between the two parts of the first and third magnets 101, 102, 103, 104.

One difference between the configurations of tables 1 and 2 is the height of the second magnets 105, 106 on the one hand and the height of the coil on the other hand. One of both is advantageously chosen larger than the other one by an amount of at least the working range in the support direction to have a small variation of the k-factor.

A further observation with regard to the configuration of Figure 5a is that the integrated magnetic flux over surface area of magnet assembly 101, 102 is substantially equal to the integrated magnetic flux over surface area of magnet assembly 103, 104 to have a small variation in, or a small value of, the parameters shown in tables 2, 3, 4, 6, 7 and 8. The configurations are not optimized and are presented, together with their simulation results, for illustrative purposes only.

A table of supporting forces as a function of the position of the second magnet assembly 105, 106 with respect to the first and third magnet assemblies 101, 102 and 103, 104, as shown in Figures 6a and 7a, can be stored in a memory device and used to control an additional supporting force by controlling an electrical current in coil 107. In this manner the supporting force can be made more constant over the working volume to yield an even lower value of the effective vertical stiffness of such a device. A similar approach can be chosen to store the values of Figure 6b or 7b in a memory device to control further actuators (not shown) acting in a plane perpendicular to the support direction, i.e. the radial direction, to further decrease the effective horizontal stiffness.

Figure 8 shows a variant of the arrangement of Figure 5a. In this arrangement the first and third magnet assemblies 101, 102, 103, 104 and 111, 112, 113, 114 are arranged in a so-called Halbach configuration. This is achieved by the addition of permanent magnets 111, 112, 113, 114 above and below the first and third magnets 101, 102, 103, 104, arranged with their magnetic polarization at an angle of 90° to that of the adjacent one of the first and third magnets. The Halbach configuration may be used to reduce the stray magnetic fields around the support and may also reduce the mass of the magnets used for a given static force.

Again, as described earlier, one of the first an third magnet assemblies of the embodiments of figures 5a and 8 might be dispensed with at the expense possibly of some additional stiffness. However, such additional stiffness may be balanced by storing a table of supporting forces over the working volume and controlling an additional force by controlling electrical current in coil 107.

Figure 9a schematically shows an arrangement that is a further variant of that shown in Figure 2a and Figure 9b shows the resulting field lines. In this case the support is intended to be a static support. The support has rotational (axial) symmetry around axis 200 and therefore the first, second and third magnets 201, 203, 202 are annular in shape. The first and third magnets are mounted on the base (schematically shown), which in this case is the floor on which the apparatus is installed, and the second magnet is mounted on the reference frame RF (schematically shown) which is being supported by the magnetic support. In use it is very important that the support has very low stiffness, as is also important for the previous arrangements, in order to isolate the reference frame (and hence key components of the apparatus) from any external vibrations. In a simplified model of a support, it can be thought of as a mass suspended by a weak spring. The natural frequency of such a system is:

$$f_n = \frac{1}{2\pi}\sqrt{\frac{k}{m}} \ [\text{Hz}]$$

in which k is the stiffness of the support and m the supported mass. The mass to be supported (per support) is typically in the order of m=1000 kg, and the maximum natural frequency is set to 0.5 Hertz (Hz). From this, the maximum allowable stiffness may be approximated to be 9900 N/m. If this is achieved then any disturbances with frequencies higher than 0.5 Hz will be attenuated, with the attenuation factor increasing with the frequency.

Table 9, below, shows dimensions of an arrangement used in simulations carried out for the configuration of Figure 9a. The dimensions given are not for an optimized arrangement of the support but are purely for illustrative purposes. The magnets are formed from NdFeB and have $\mu_r$=1.05 and $B_r$=1.38 T. The simulations show a vertical force of 8311 N $\pm$ 0.01% and a maximal value of absolute vertical stiffness of 2750 N/m for movements in the vertical support direction from 0 to 1 mm.

The support of the reference frame RF may also be provided in an arrangement of Figure 5a to have a coil for producing a positioning force in the support direction on the frame and/or to further decrease the stiffness.

In the arrangements described above the first and second magnets and the coil, where applicable, are mounted on the base and the third magnet(s) are mounted on the element being supported. In other arrangements according to the present invention, however, this may be reversed. Furthermore, the static and dynamic supports according to the present invention, and described above, may be used to support elements of the lithographic apparatus other than those specifically described above.

Figure 10 show another embodiment of the magnetic support, which comprises an upper magnet 301 having a magnetic polarization oriented downward and a lower magnet 302 having a magnetic polarization oriented upwards. Both magnets are permanent magnets and have an annular configuration around a common vertical axis. Permanent magnet 303 is located in a space in between magnets 301 and 302 and is also rotationally symmetric around the common vertical axis. Magnets 301 and 302 are attached to a base part and magnet 303 to a supported part, or vice versa.

Figure 11 shows yet another embodiment of the magnetic support that is also a variation to embodiments already described. The figure 11 embodiment has rotational symmetry around a vertical axis and comprises inner permanent magnets 101 and 102 of a first magnet assembly having a magnetic polarization along the symmetry axis parallel (or anti-parallel) to the support direction. Another permanent magnet 105 of a second magnet assembly having an annular configuration is arranged around the first magnet assembly. Magnet 105 has a radial magnetization in a direction perpendicular to the support direction. The large axially magnetized inner magnet 101 together with the radially magnetized magnet 105 basically provide the magnetic supporting force. Thin axial magnetized magnet 102 is to be regarded as a tuning magnet. By altering the gap between magnets 101 and 102 by adjustment means 110 the nominal supporting force can be adjusted.

Figure 11 further shows a coil 107 provided around magnet 105 and attached to the base part. An electrical current carried by the electrical windings of the coil will interact with the radial magnetic field component of magnet 105 so as to provide a additional force in the vertical direction. Dependent on the direction of the electrical current, the force will be directed up or down.

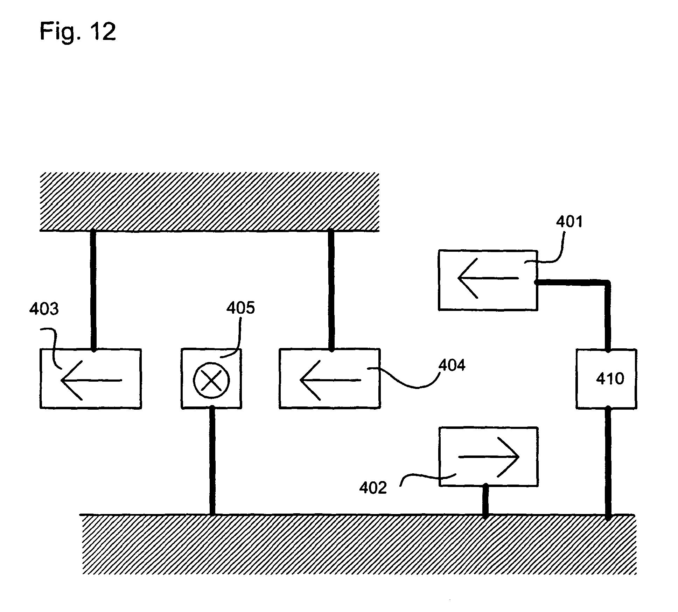

Figure 12 shows yet another variant of a magnetic support including a current carrying element for an additional vertical force and having magnets of which a relative position is adjustable for adjusting a nominal supporting force. The figure shows a first magnet assembly having annular permanent magnets 401 and 402 with magnetic polarizations directed as shown in the figure, and further shows a second magnet assembly having annular permanent magnets 403 and 404 with magnetic polarizations as shown. The configurations yields a magnetic supporting force that may be adjusted by adjusting the vertical gap between magnets 401 and 402 by adjustment means 410. A coil 405 provides for an additional vertical force that may be directed up or down dependent on an electrical current carried by the windings of the coil.

Whilst specific embodiments of the invention have been described above, it will be appreciated that the invention may be practiced otherwise than as described. The description is not intended to limit the invention. Specifically, no conclusions should be drawn from the relative sizes or the shapes of the elements shown in the Figures or described in the illustrative examples above. The size and shape of each element may be varied in order to optimize the performance of the arrangement.

*Table 1: Dimensions of elements in a first simulation*

| Element | $\varnothing_{inner}$ (mm) | $\varnothing_{outer}$ (mm) | Height (mm) |
|---------|-----------|-----------|-------------|
| 101 | 11 | 20 | 12.4 |
| 102 | 11 | 20 | 12.4 |
| 103 | 88 | 91 | 12.4 |
| 104 | 88 | 91 | 12.4 |
| 105 | 32 | 44 | 10 |
| 106 | 64 | 75 | 10 |
| 107 | 50 | 60 | 14 |

*Table 2: Properties when magnet gap d1 = d2 = 0.2 mm in a first simulation*

| Property | Value | Unit |
|---|---|---|
| Nominal vertical force | 88.40 | N |
| Maximal vertical stiffness | -170 | N/m |
| Maximal horizontal stiffness | -128 | N/m |
| Maximal variation of vertical force | 0.1 | % |
| Maximal absolute value of horizontal force | 0.18 | N |
| Maximal absolute value of torque | 13.5 | mNm |
| Nominal k-factor | 0.0310 | N/A |
| Maximal variation of k-factor | 0.97 | % |

*Table 3: Properties when magnet gap d1 = d2 = 0.4 mm in a first simulation*

| Property | Value | Unit |
|---|---|---|
| Nominal vertical force | 85.10 | N |
| Maximal vertical stiffness | -270 | N/m |
| Maximal horizontal stiffness | -129 | N/m |
| Maximal variation of vertical force | 0.2 | % |
| Maximal absolute value of horizontal force | 0.18 | N |
| Maximal absolute value of torque | 9.1 | mNm |
| Nominal k-factor | 0.0310 | N/A |
| Maximal variation of k-factor | 0.97 | % |

*Table 4: Properties for GC when magnet gap d1 = d2 = 0.6 mm in a first simulation*

| Property | Value | Unit |
|---|---|---|
| Nominal vertical force | 81.82 | N |
| Maximal vertical stiffness | -430 | N/m |
| Maximal horizontal stiffness | -126 | N/m |
| Maximal variation of vertical force | 0.3 | % |
| Maximal absolute value of horizontal force | 0.19 | N |
| Maximal absolute value of torque | 4.7 | mNm |
| Nominal k-factor | 0.0310 | N/A |
| Maximal variation of k-factor | 0.97 | % |

*Table 5: Dimensions of elements in a second simulation*

| Element | $\varnothing_{inner}$ (mm) | $\varnothing_{outer}$ (mm) | Height (mm) |
|---|---|---|---|
| 101 | 10 | 20 | 12.65 |
| 102 | 10 | 20 | 12.65 |
| 103 | 72 | 74 | 12.65 |

(continued)

| Element | $\varnothing_{inner}$ (mm) | $\varnothing_{outer}$ (mm) | Height (mm) |
|---|---|---|---|
| 104 | 72 | 74 | 12.65 |
| 105 | 31 | 37 | 16 |
| 106 | 55 | 61 | 16 |
| 107 | 43 | 51 | 12 |

Table 6: Properties when magnet gap d1 = d2 = 0.2 mm in a second simulation

| Property | Value | Unit |
|---|---|---|
| Nominal vertical force | 93.11 | N |
| Maximal vertical stiffness | 200 | N/m |
| Maximal horizontal stiffness | 212 | N/m |
| Maximal variation of vertical force | 0.2 | % |
| Maximal absolute value of horizontal force | 0.40 | N |
| Maximal absolute value of torque | 8.8 | mNm |
| Nominal k-factor | 0.0241 | N/A |
| Maximal variation of k-factor | 1.50 | % |

Table 7: Properties when magnet gap d1 = d2 = 0.4 mm in a second simulation

| Property | Value | Unit |
|---|---|---|
| Nominal vertical force | 90.60 | N |
| Maximal vertical stiffness | 310 | N/m |
| Maximal horizontal stiffness | 178 | N/m |
| Maximal variation of vertical force | 0.15 | % |
| Maximal absolute value of horizontal force | 0.35 | N |
| Maximal absolute value of torque | 9.9 | mNm |
| Nominal k-factor | 0.0241 | N/A |
| Maximal variation of k-factor | 1.50 | % |

Table 8: Properties when magnet gap d1 = d2 = 0.6 mm in a second simulation

| Property | Value | Unit |
|---|---|---|
| Nominal vertical force | 88.08 | N |
| Maximal vertical stiffness | 240 | N/m |
| Maximal horizontal stiffness | 149 | N/m |
| Maximal variation of vertical force | 0.12 | % |
| Maximal absolute value of horizontal force | 0.30 | N |
| Maximal absolute value of torque | 11.0 | mNm |
| Nominal k-factor | 0.0241 | N/A |
| Maximal variation of k-factor | 1.50 | % |

*Table 9: Dimensions of elements in a third simulation*

| Element | $\varnothing_{inner}$ (mm) | $\varnothing_{outer}$ (mm) | Height (mm) |
|---------|------------|------------|-------------|
| 201 | 10 | 120 | 140 |
| 202 | 380 | 420 | 140 |
| 203 | 192 | 312 | 84 |

**Claims**

1. A lithographic projection apparatus comprising:

   - a radiation (IL) system for providing a projection beam of radiation (PB);
   - a support structure (MT) for supporting patterning means (MA), the patterning means serving to pattern the projection beam according to a desired pattern;
   - a substrate table (WT) for holding a substrate (W);
   - a projection system (PL) for projecting the patterned beam onto a target portion (C) of the substrate; and
   - a support that provides a magnetic force in a first, support, direction between a first part and a second part of the apparatus, wherein the support comprises first, second and third magnet assemblies and:

      - said first and third magnet assemblies are attached to said first part and each comprises at least one magnet (1,2; 11,12) orientated such that its magnetic polarization is substantially parallel or anti-parallel to said first direction;
      - said second magnet assembly is attached to the second part and comprises at least one magnet (3;13); and
      - said at least one magnet (3; 13) of said second magnet assembly has its magnetic polarization orientated so as to produce a bias force substantially along said first direction by magnetic interaction between said first, second and third magnet assemblies;

   **characterised in that** said first and third magnet assemblies are set apart in a direction that is substantially perpendicular to the first direction and define a space between them; and said second magnet assembly is at least partly located in said space.

2. A lithographic projection apparatus according to claim 1, wherein at least one of said first, second and third magnet assemblies comprises at least one permanent magnet.

3. A lithographic projection apparatus according to claim 1 or 2, wherein said second magnet assembly at least substantially circumscribes said first magnet assembly and said third magnet assembly substantially circumscribes said second magnet assembly in a plane perpendicular to said first direction.

4. A lithographic projection apparatus according to claim 3, wherein said magnet assemblies are at least substantially rotationally symmetric around a common axis substantially parallel to said first direction.

5. A lithographic projection apparatus according to any one of claims 1 to 4, wherein at least one of said first and third magnet assemblies comprises two magnets (101, 102, 103, 104) and a means for adjusting the relative position of said two magnets so as to adjust said bias force.

6. A lithographic projection apparatus according to claim 5, wherein said two magnets are spaced apart in a direction substantially parallel to the first direction to define an adjustable gap therebetween.

7. A lithographic projection apparatus according to any one of claims 1 to 6, wherein a magnet (13) of said third magnet assembly is orientated such that its magnetic polarization is substantially parallel to that of a magnet (11) of the first magnet assembly; and a first magnet (13) of the second magnet assembly is orientated such that its magnetic polarization is substantially parallel or anti-parallel to that of a magnet of the first magnet assembly so as to provide the bias force.

8. A lithographic projection apparatus according to claim 7, wherein said second magnet assembly further comprises a second (14) magnet orientated such that its magnetic polarization is substantially anti-parallel to that of the first magnet (13) of the second magnet assembly so as to provide a further bias force in the first direction.

9. A lithographic projection apparatus according to any one of claims 1 to 6, wherein a magnet (2) of said third magnet assembly is orientated such that its magnetic polarization is substantially anti-parallel to that of a magnet (1) of the first magnet assembly; and a first magnet (3) of the second magnet assembly is orientated such that its magnetic polarization is substantially perpendicular to that of a magnet of the first magnet assembly so as to provide the bias force.

10. A lithographic projection apparatus according to claim 1 or 2, at wherein at least one of said first and third magnet assemblies has a substantially rotationally symmetric configuration around an axis along the first direction.

11. A lithographic projection apparatus according to any one of claims 1 to 10, wherein said support further comprises an electrically conductive element (7) connectable to a power supply, said electrically conductive element being arranged so as to produce a force between said first and second parts by interaction of an electrical current carried by said electrically conductive element and a magnetic field of at least one of said first, second and third magnet assemblies.

12. A lithographic projection apparatus according to claim 9, wherein said second magnet assembly has its magnetic polarization substantially oriented parallel or anti-parallel to said second direction, and wherein said support further comprises an electrically conductive element (7) connectable to a power supply, said electrically conductive element being attached to said first part so as to produce a force parallel to said first direction between said first and second parts by interaction of an electrical current carried by said electrically conductive element and a magnetic field of said second magnet assembly.

13. A lithographic projection apparatus according to claim 12, wherein said second magnet assembly comprises two magnets (105, 106) spaced apart in said second direction to define a further space there between and orientated such that their magnetic polarizations are substantially parallel, and wherein said electrically conductive element (107) is at least partly located in said further space.

14. A lithographic projection apparatus according to claim 12 or 13, wherein a dimension in said first direction of the electrically conductive element is significantly larger or significantly smaller than that of a magnet of the second magnet assembly.

15. A lithographic projection apparatus according to any one of claims 1 to 14, wherein one of said first and second parts is supported by the other one of said first and second parts by means of the support, and wherein said supported one part is one of said support structure (MT), said substrate table (WT), and an isolated reference frame.

16. A lithographic projection apparatus according to any one of claims 11 to 14, wherein the first part of the apparatus supports the second part of the apparatus by means of the support; and the electrically conductive element (107) is attached to the first part, and wherein said supported second part is one of said support structure (MT), said substrate table (WT), and an isolated reference frame.

17. A device manufacturing method comprising the steps of:

- providing a substrate (W) that is at least partially covered by a layer of radiation-sensitive material;
- providing a projection beam of radiation (PB) using a radiation system (IL);
- using patterning means (MA) to endow the projection beam with a pattern in its cross-section;
- projecting the patterned beam of radiation onto a target portion (C) of the layer of radiation-sensitive material;
- providing a support that provides a magnetic force in a first, support, direction between a first part and a second part of the apparatus, comprising first, second and third magnet assemblies, and in that:
- said first and third magnet assemblies are attached to said first part and each comprises at least one magnet (1,2; 11,12) orientated such that its magnetic polarization is substantially parallel or anti-parallel to said first direction;
- said second magnet assembly is attached to the second part and comprises at least one magnet (3;13); and
- said at least one magnet (3;13) of said second magnet assembly has its magnetic polarization orientated so as to produce a bias force substantially along said support direction by magnetic interaction between said first, second and third magnet assemblies;

**characterised in that** said first and third magnet assemblies are set apart in a direction that is substantially perpendicular to the first direction and define a space between them; and
said second magnet assembly is at least partly located in said space.

## Patentansprüche

1. Lithographische Projektionsvorrichtung, mit:

   • einem Strahlungssystem (IL) zur Bereitstellung eines Projektionsstrahls aus Strahlung (PB);
   • einer Haltekonstruktion (MT) zum Halten von Musteraufbringungseinrichtungen (MA), wobei die Musteraufbringungseinrichtungen dazu dienen, den Projektionsstrahl gemäß einem gewünschten Muster zu mustern;
   • einem Substrattisch (WT) zum Halten eines Substrats (W);
   • einem Projektionssystem (PL) zum Projizieren des gemusterten Strahls auf einen Zielbereich (C) des Substrats; und mit
   • einer Halterung, die eine magnetische Kraft in einer ersten Abstützrichtung zwischen einem ersten Teil und einem zweiten Teil der Vorrichtung bereitstellt, wobei die Halterung erste, zweite und dritte Magnetanordnungen umfasst, und wobei:

   - die ersten und dritten Magnetanordnungen an dem ersten Teil befestigt sind und jeweils wenigstens einen Magneten (1,2; 11,12) umfassen, der so ausgerichtet ist, dass seine magnetische Polarisation im Wesentlichen parallel oder antiparallel zu der ersten Richtung ist;
   - die zweite Magnetanordnung am zweiten Teil befestigt ist und wenigstens einen Magneten (3;13) umfasst; und wobei
   - die magnetische Polarisation des wenigstens einen Magnets (3;13) der zweiten Magnetanordnung so ausgerichtet ist, dass sie im Wesentlichen in der ersten Richtung eine Vorspannkraft durch magnetische Interaktion zwischen der ersten, zweiten und dritten Magnetanordnung erzeugt;

   **dadurch gekennzeichnet, dass** die erste und die dritte Magnetanordnung in einer Richtung beabstandet sind, die im Wesentlichen senkrecht zur ersten Richtung ist und einen Raum zwischen ihnen definiert; und dass die zweite Magnetanordnung wenigstens teilweise in dem Zwischenraum angeordnet ist.

2. Lithographische Projektionsvorrichtung nach Anspruch 1, wobei wenigstens eine der ersten, zweiten und dritten Magnetanordnung wenigstens einen Permanentmagneten umfasst.

3. Lithographische Projektionsvorrichtung nach Anspruch 1 oder 2, wobei die zweite Magnetanordnung die ersten Magnetanordnung wenigstens im Wesentlichen begrenzt und wobei die dritte Magnetanordnung im Wesentlichen die zweite Magnetanordnung in einer zu der ersten Richtung senkrechten Ebene begrenzt.

4. Lithographische Projektionsvorrichtung nach Anspruch 3, wobei die Magnetanordnungen um eine gemeinsame Achse im Wesentlichen parallel zu der ersten Richtung wenigstens im Wesentlichen rotationssymmetrisch sind.

5. Lithographische Projektionsvorrichtung nach einem der Ansprüche 1 bis 4, wobei wenigstens eine der ersten und dritten Magnetanordnungen zwei Magnete (101, 102, 103, 104) und eine Einrichtung zum Anpassen der relativen Position der beiden Magnete umfasst, um die Vorspannkraft anzupassen.

6. Lithographische Projektionsvorrichtung nach Anspruch 5, wobei die beiden Magnete in einer Richtung beabstandet sind, die im Wesentlichen parallel zu der ersten Richtung verläuft, um einen anpassbaren Spalt zwischen ihnen zu definieren.

7. Lithographische Projektionsvorrichtung nach einem der Ansprüche 1 bis 6, wobei ein Magnet (13) der dritten Magnetanordnung derart ausgerichtet ist, dass seine magnetische Polarisation im Wesentlichen parallel zu der eines Magneten (11) der ersten Magnetanordnung ist; und wobei ein erster Magnet (13) der zweiten Magnetanardnung derart ausgerichtet ist, dass seine magnetische Polarisation im Wesentlichen parallel oder antiparallel zu der eines Magneten der ersten Magnetanordnung ist, um die Vorspannkraft bereitzustellen.

8. Lithographische Projektionsvorrichtung nach Anspruch 7, wobei die zweite Magnetanordnung ferner einen zweiten (14) Magneten umfasst, der derart ausgerichtet ist, dass seine magnetische Polarisation im Wesentlichen antiparallel zu der des ersten Magneten (13) der zweiten Magnetanordnung ist, um eine weitere Vorspannkraft in die erste Richtung bereitzustellen.

9. Lithographische Projektionsvorrichtung nach einem der Ansprüche 1 bis 6, wobei ein Magnet (2) der dritten Magnetanordnung derart ausgerichtet ist, dass seine magnetische Polarisation im Wesentlichen antiparallel zu der eines Magneten (1) der ersten Magnetanordnung ist; und wobei ein erster Magnet (3) der zweiten Magnetanordnung derart ausgerichtet ist, dass seine magnetische Polarisation im Wesentlichen senkrecht zu der eines Magneten der ersten Magnetanordnung ist, um die Vorspannkraft bereitzustellen.

10. Lithographische Projektionsvorrichtung nach Anspruch 1 oder 2, wobei wenigstens eine der ersten und dritten Magnetanordnungen eine im Wesentlichen rotationssymmetrische Konfiguration um eine Achse entlang der ersten Richtung aufweist.

11. Lithographische Projektionsvorrichtung nach einem der Ansprüche 1 bis 10, wobei die Halterung ferner ein elektrisch leitfähiges Element (7) umfasst, das an eine Stromversorgung angeschlossen werden kann, wobei das elektrisch leitfähige Element so angeordnet ist, dass es eine Kraft erzeugt zwischen dem ersten und zweiten Teil durch Interaktion eines elektrischen Stroms, der von dem elektrisch leitfähigen Element geleitet wird, und einem Magnetfeld aus wenigstens einer der ersten, zweiten und dritten Magnetanordnungen.

12. Lithographische Projektionsvorrichtung nach Anspruch 9, wobei die magnetische Polarisation der zweiten Magnetanordnung im Wesentlichen parallel oder antiparallel zu der zweiten Richtung ist, und wobei die Halterung ferner ein elektrisch leitfähiges Element (7) umfasst, das an eine Stromversorgung angeschlossen werden kann, wobei das elektrisch leitfähige Element am ersten Teil befestigt ist, um eine Kraft parallel zu der ersten Richtung zu erzeugen zwischen dem ersten und zweiten Teil durch Interaktion eines elektrischen Stroms, der von dem elektrisch leitfähigen Element geleitet wird, und einer magnetischen Kraft der zweiten Magnetanordnung.

13. Lithographische Projektionsvorrichtung nach Anspruch 12, wobei die zweite Magnetanordnung zwei Magnete (105, 106) umfasst, die in der zweiten Richtung beabstandet sind, um einen weiteren Raum zwischen ihnen zu definieren und so ausgerichtet sind, dass ihre magnetische Polarisation im Wesentlichen parallel ist, und wobei das elektrisch leitfähige Element (107) wenigstens teilweise in dem weiteren Zwischenraum angeordnet ist.

14. Lithographische Projektionsvorrichtung nach Anspruch 12 oder 13, wobei eine Dimension in die erste Richtung des elektrisch leitfähigen Elements erheblich größer oder erheblich kleiner ist als diejenige eines Magneten der zweiten Magnetanordnung.

15. Lithographische Projektionsvorrichtung nach einem der Ansprüche 1 bis 14, wobei eines der ersten und zweiten Teile von dem anderen der ersten und zweiten Teile mittels der Halterung abgestützt wird, und wobei das abgestützte eine Teil entweder die Haltekonstruktion (MT), der Substrattisch (WT) oder ein Isolierter Referenzrahmen Ist.

16. Lithographische Projektionsvorrichtung nach einem der Ansprüche 11 bis 14, wobei der erste Teil der Vorrichtung den zweiten Teil der Vorrichtung mittels der Halterung abstützt; und wobei das elektrisch leitfähige Element (107) am ersten Teil befestigt ist, und wobei der abgestützte zweite Teil entweder die Haltekonstruktion (MT), der substrattisch (WT) oder ein isolierter Referenzrahmen ist.

17. Verfahren zur Herstellung eines Bauelements, das folgende Schritte umfasst:

• Bereitstellen eines Substrats (W), das wenigstens teilweise von einer Schicht aus strahlungssensitivem Material bedeckt ist;
• Bereitstellen eines Projektionsstrahls aus Strahlung (PB) unter Verwendung eines Strahlungssystems (IL);
• Verwenden von Musteraufbringungseinrichtungen (MA), um den Projektionsstrahl in seinem Querschnitt mit einem Muster zu versehen;
• Projizieren des gemusterten Strahls aus Strahlung auf einen Zleibereich (C) der Schicht aus strahlungssensitivem Material;
• Bereitstellen einer Halterung, die eine Magnetkraft in einer ersten Abstützrichtung zwischen einem ersten Teil und einem zweiten Teil der Vorrichtung bereitstellt und erste, zweite und dritte Magnetanordnungen umfasst, und dass:
• die erste und die dritte Magnetanordnung am ersten Teil befestigt sind und jewells wenigstens einen Magneten (1,2; 11,12) umfasst, der derart ausgerichtet ist, dass seine magnetische Polarisation im Wesentlichen parallel oder antiparallel zur ersten Richtung ist;

• die zweite Magnetanordnung am zweiten Teil befestigt ist und wenigstens einen Magneten (3;13) umfasst; und

• die magnetische Polarisation des wenigstens einen Magneten (3;13) der zweiten Magnetanordnung so ausgerichtet ist, dass sie eine Vorspannkraft im Wesentlichen entlang der Halterichtung durch magnetische Interaktion zwischen der ersten, der zweiten und der dritten Magnetanordnung erzeugt;

**dadurch gekennzeichnet, dass** die erste und die dritte Magnetanordnung in einer Richtung angeordnet sind, die im Wesentlichen senkrecht zur ersten Richtung ist und einen Raum zwischen ihnen definiert; und dass die zweite Magnetanordnung wenigstens teilweise In dem Zwischenraum angeordnet ist.

## Revendications

1. Appareil de projection lithographique comprenant :

   - un système de rayonnement (IL) pour délivrer un faisceau de projection (PB) de rayonnement ;
   - une structure de support (MT) pour supporter des moyens de mise en forme (MA), les moyens de mise en forme servant à mettre en forme le faisceau de projection conformément à un motif voulu ;
   - une table de substrat (WT) pour maintenir un substrat (W) ;
   - un système de projection (PL) pour projeter le faisceau mis en forme sur une partie cible (C) du substrat ; et
   - un support qui produit une force magnétique dans une première direction de support entre une première partie et une seconde partie de l'appareil, dans lequel le support comprend des premier, deuxième et troisième ensembles à aimant et :

     - lesdits premier et troisième ensembles à aimant sont fixés sur ladite première partie et chacun comprend au moins un aimant (1, 2 ; 11, 12) orienté de sorte que sa polarisation magnétique est sensiblement parallèle ou antiparallèle à ladite première direction ;
     - ledit deuxième ensemble à aimant est fixé sur la seconde partie et comprend au moins un aimant (3 ; 13) ; et
     - ledit au moins un aimant (3 ; 13) dudit deuxième ensemble à aimant a sa polarisation magnétique orientée de manière à produire une force de polarisation sensiblement le long de ladite première direction par une interaction magnétique entre lesdits premier, deuxième et troisième ensembles à aimant ;

   **caractérisé en ce que** lesdits premier et troisième ensembles à aimant sont écartés dans une direction qui est sensiblement perpendiculaire à la première direction et définissent un espace entre eux ; et ledit deuxième ensemble à aimant est au moins partiellement situé dans ledit espace.

2. Appareil de projection lithographique selon la revendication 1, dans lequel au moins un parmi lesdits premier, deuxième et troisième ensembles à aimant comprend au moins un aimant permanent.

3. Appareil de projection lithographique selon la revendication 1 ou 2, dans lequel ledit deuxième ensemble à aimant délimite au moins sensiblement ledit premier ensemble à aimant et ledit troisième ensemble à aimant délimité sensiblement ledit deuxième ensemble à aimant dans un plan perpendiculaire à ladite première direction.

4. Appareil de projection lithographique selon la revendication 3, dans lequel lesdits ensembles à aimant sont au moins sensiblement symétriques en rotation autour d'un axe commun sensiblement parallèle à ladite première direction.

5. Appareil de projection lithographique selon l'une quelconque des revendications 1 à 4, dans lequel au moins un parmi lesdits premier, et troisième ensembles à aimant comprend deux aimants (101, 102, 103, 104) et des moyens pour régaler la position relative desdits deux aimants de manière à régler ladite force de polarisation.

6. Appareil de projection lithographique selon la revendication 5, dans lequel lesdits deux aimants sont écartés dans une direction sensiblement parallèle à la première direction pour définir un espace réglable entre eux.

7. Appareil de projection lithographique selon l'une quelconque des revendications 1 à 6, dans lequel un aimant (13) dudit troisième ensemble à aimant est orienté de sorte que sa polarisation magnétique est sensiblement parallèle à celle d'un aimant (11) du premier ensemble à aimant ; et un premier aimant (13) du deuxième ensemble à aimant est orienté de sorte que sa polarisation magnétique est sensiblement parallèle ou antiparallèle à celle d'un aimant du premier ensemble à aimant de manière à produire la force de polarisation.

8. Appareil de projection lithographique selon la revendication 7, dans lequel ledit deuxième ensemble à aimant comprend en outre un second aimant (14) orienté de sorte que sa polarisation magnétique est sensiblement antiparallèle à celle du premier aimant (13) du deuxième ensemble à aimant de manière à produire une force de polarisation supplémentaire dans la première direction.

9. Appareil de projection lithographique selon l'une quelconque des revendication 1 à 6, dans lequel un aimant (2) dudit troisième ensemble à aimant est orienté de sorte que sa polarisation magnétique est sensiblement antiparallèle à celle d'un aimant (1) du premier ensemble à aimant ; et un premier aimant (3) du deuxième ensemble à aimant est orienté de sorte que sa polarisation magnétique est sensiblement perpendiculaire à celle d'un aimant du premier ensemble à aimant de manière à produire la force de polarisation.

10. Appareil de projection lithographique selon la revendication 1 ou 2, dans lequel au moins un parmi lesdits premier et troisième ensembles à aimant a une configuration sensiblement symétrique en rotation autour d'un axe le long de la première direction.

11. Appareil de projection lithographique selon l'une quelconque des revendications 1 à 10, dans lequel ledit support comprend en outre un élément électriquement conducteur (7) pouvant être relié à une alimentation, ledit élément électriquement conducteur étant agencé de manière à produire une force entre lesdites première et seconde parties par interaction d'un courant électrique transporté par ledit élément électriquement conducteur et un champ magnétique d'au moins un parmi lesdits premier, deuxième et troisième ensembles à aimant.

12. Appareil de projection lithographique selon la revendication 9, dans lequel ledit deuxième ensemble à aimant a sa polarisation magnétique sensiblement orientée parallèle ou antiparallèle à ladite seconde direction, et dans lequel ledit support comprend en outre un élément électriquement conducteur (7) pouvant être relié à une alimentation, ledit élément électriquement conducteur étant fixé sur ladite première partie de manière à produire une force parallèle à ladite première direction entre lesdites première et seconde parties par interaction d'un courant électrique transporté par ledit élément électriquement conducteur et un champ magnétique dudit deuxième ensemble à aimant.

13. Appareil de projection lithographique selon la revendication 12, dans lequel ledit deuxième ensemble à aimant comprend deux aimants (105, 106) écartés dans ladite seconde direction pour définir un espace supplémentaire entre ceux-ci et orientés de sorte que leurs polarisations magnétiques sont sensiblement parallèles, et dans lequel ledit élément électriquement conducteur (107) est au moins partiellement situé dans ledit espace supplémentaire.

14. Appareil de projection lithographique selon la revendication 12 ou 13, dans lequel une dimension dans ladite première direction de l'élément électriquement conducteur est considérablement plus grande ou considérablement plus petite que celle d'un aimant du deuxième ensemble à aimant.

15. Appareil de projection lithographique selon l'une quelconque des revendications 1 à 14, dans lequel une parmi lesdites première et seconde parties est supportée par l'autre desdites première et seconde parties au moyen du support, et dans lequel ladite partie supportée est un élément parmi ladite structure de support (MT), ladite table de substrat (WT) et un châssis de référence isolé.

16. Appareil de projection lithographique selon l'une quelconque des revendications 11 à 14, dans lequel la première partie de l'appareil supporte la seconde partie de l'appareil au moyen du support ; et l'élément électriquement conducteur (107) est fixé sur la première partie, et dans lequel ladite seconde partie supportée est un élément parmi ladite structure de support (MT), ladite table de substrat (WT) et un châssis de référence isolé.

17. Procédé de fabrication d'un dispositif comprenant les étapes de :

- fournir un substrat (W) qui est au moins partiellement recouvert d'une couche de matériau sensible au rayonnement ;
- délivrer un faisceau de projection (PB) de rayonnement utilisant un système de rayonnement (IL) ;
- utiliser des moyens de mise en forme (MA) pour doter le faisceau de projection d'un motif dans sa section transversale ;
- projeter le faisceau de rayonnement mis en forme sur une partie cible (C) de la couche de matériau sensible au rayonnement ;
- fournir un support qui produit une force magnétique dans une première direction de support entre une première partie et une seconde partie de l'appareil, comprenant des premier, deuxième et troisième ensembles à aimant, et en ce que :

- lesdits premier et troisième ensembles à aimant sont fixés sur ladite première partie et chacun comprend au moins un aimant (1, 2 ; 11, 12) orienté de sorte que sa polarisation magnétique est sensiblement parallèle ou antiparallèle à ladite première direction ;
- ledit deuxième ensemble à aimant est fixé sur la seconde partie et comprend au moins un aimant (3 ; 13) ; et
- ledit au moins un aimant (3 ; 13) dudit deuxième ensemble à aimant a sa Polarisation magnétique orientée de manière à produire une force de Polarisation sensiblement le long de ladite direction de support par une interaction magnétique entre lesdits premier, deuxième et troisième ensembles à aimant ;

**caractérisé en ce que** lesdits premier et troisième ensembles à aimant sont écartés dans une direction qui est sensiblement perpendiculaire à la première direction et définissent un espace entre eux ; et ledit deuxième ensemble à aimant est au moins partiellement situé dans ledit espace.

## Fig. 1

## Fig. 2a

## Fig. 2b

## Fig. 3a

11b

11

11a

13a

13

13b

12a

12

12b

## Fig. 3b

## Fig. 4a

## Fig. 4b

Fig. 5a

Fig. 5b

## Fig. 6a

## Fig. 6b

## Fig. 7a

## Fig. 7b

## Fig. 8

## Fig. 9a

## Fig. 9b

Fig. 10

301

303

302

Fig. 11

102

105

107

110

101

Fig. 12

**EP 1 265 105 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5296891 A
- US 5523193 A
- US 5229872 A
- US 6046792 A
- US 5969441 A
- WO 9840791 A
- WO 9905573 A
- EP 0973067 A
- EP 1001512 A
- US 5780943 A